# FASCICULE DE BREVET EUROPEEN

(11) **EP 3 190 861 B1**
(45) Date de publication et mention de la délivrance du brevet: **15.08.2018**
(21) Numéro de dépôt: 17150802.1
(22) Date de dépôt: 10.01.2017
(51) Int. Cl.: B60Q 1/00, F21V 25/00, H01S 5/062, H05B 33/08, F21S 41/14, F21S 41/40

(54) **MODULE LUMINEUX POUR UN VEHICULE AUTOMOBILE IMPLIQUANT UNE SOURCE LUMINEUSE COHERENTE A INTENSITE MODULEE**
LEUCHTMODUL FÜR EIN KRAFTFAHRZEUG, DAS EINE KOHÄRENTE LEUCHTQUELLE MIT MODULIERTER INTENSITÄT UMFASST
LIGHT MODULE FOR A MOTOR VEHICLE INVOLVING A COHERENT LIGHT SOURCE WITH MODULATED INTENSITY

(30) Priorité: 11.01.2016 FR 1650202
(43) Date de publication de la demande: 12.07.2017
(73) Titulaire: Valeo Vision, 93012 Bobigny Cedex (FR)
(72) Inventeur: KRICK, Sebastian, 75019 PARIS (FR)

(56) Documents cités:
- JP-A- 2013 168 585
- US-A1- 2011 063 115
- US-A1- 2014 009 952

## Description

L'invention a trait au domaine des projecteurs d'éclairage, notamment pour véhicule automobile. L'invention traite d'un projecteur d'éclairage ayant une source lumineuse cohérente.

Un véhicule automobile est équipé de projecteurs, ou phares, destinés à illuminer la route devant le véhicule, la nuit ou en cas de luminosité réduite. Il est connu d'utiliser des sources lumineuses aptes à émettre de la lumière cohérente dans des projecteurs pour véhicules automobiles. Il s'agit par exemple d'éléments semi-conducteurs tels que des diodes laser. De manière connue, des sources lumineuses à éléments semi-conducteurs sont alimentées en électricité dans de tels dispositifs par le biais de convertisseurs DC/DC. Un tel convertisseur est apte à convertir un courant d'une première intensité, fourni par exemple par une batterie du véhicule automobile, en un courant d'une deuxième intensité différente de la première, et adapté à alimenter les éléments semi-conducteurs en électricité. Le document US20110063115 A1 divulgue un projecteur équipé d'une source lumineuse, dans lequel une lumière cohérente est émise, puis est convertie en lumière incidente et ensuite est détectée par un capteur optique pour être comparée avec un seuil prédéterminé, afin de déterminer si l'alimentation de la dite source doit être arrêtée par sécurité. Des systèmes lumineux à diodes lasers fonctionnent en général selon un principe de diffusion de la lumière cohérente pour la rendre incohérente. La lumière incohérente ainsi obtenue est alors émise par le système lumineux. La conversion de la lumière cohérente en lumière incohérente est une étape importante pour des raisons de sécurité, puisque la lumière cohérente peut avoir des effets néfastes sur l'oeil humain. Il est connu de proposer un dispositif lumineux pour un véhicule automobile comprenant une diode laser qui illumine un élément phosphore de lumière laser monochromatique, par exemple de la lumière laser bleue. L'élément phosphore convertit la lumière cohérente incidente en lumière incohérente. De tels dispositifs lumineux comprennent généralement des systèmes de sécurité comprenant des filtres optiques et des capteurs aptes à discerner la lumière monochromatique, issue directement de la source lumineuse d'une part, et la lumière incohérente convertie par l'élément diffuseur d'autre part. En effet, un filtre optique dont la bande passante comprend la couleur de la source cohérente monochromatique peut être utilisé pour une telle mise en oeuvre. Cependant, de tels dispositifs connus dans l'art ne sont pas robustes à la lumière ambiante extérieure, qui peut être incidente sur le filtre et/ou capteur sans être générée par le la source cohérente et l'élément diffuseur. Ce défaut peut amener le système de sécurité à générer des faux positifs ou négatifs.

L'invention a pour objectif de pallier à au moins un des problèmes posés par l'art antérieur. Plus précisément, l'invention a pour objectif de proposer un dispositif et un procédé qui présentent une sécurité accrue par rapport aux dispositifs connus dans l'art, notamment en rapport avec la détection de défauts engendrant un échappement probable de lumière cohérente.

L'invention a pour objet un module lumineux pour un véhicule automobile. Le module lumineux comprend une source lumineuse apte à émettre de la lumière cohérente, des moyens de modulation destinés à moduler l'intensité de la lumière émise par ladite source moyennant un signal de modulation et des moyens de conversion agencés de sorte qu'au moins une partie de la lumière cohérente incidente en provenance de ladite source soit convertie en lumière incohérente. Le module lumineux est remarquable en ce qu'il comprend en outre des moyens d'obtention d'un signal de variation, indiquant la variation de l'intensité lumineuse d'une lumière incidente, disposés en aval des moyens de conversion, et des moyens de commande de la source lumineuse qui sont configurés pour comparer le signal de variation au signal de modulation et pour commander le fonctionnement de ladite source lumineuse suite à la comparaison dudit signal de variation au signal de modulation.

De préférence, le signal de modulation peut présenter une allure sinusoïdale, ou présenter une alternance entre aux moins deux valeurs continues.

De préférence, les moyens de conversion peuvent être alignés avec une direction d'émission de rayons lumineux de la source lumineuse. Les moyens d'obtention peuvent de préférence être alignés avec ladite direction d'émission en aval de ladite source.

Le terme « en aval » s'entend au sens du trajet, direct ou indirect, des rayons lumineux émis par la source lumineuse. Par conséquent, des moyens de déviation optique peuvent être interposés entre les moyens de conversion et les moyens d'obtention en étant agencés pour dévier de la lumière convertie depuis les moyens de conversion vers les moyens d'obtention, ces moyens d'obtention restant donc disposés en aval des moyens de conversion.

Les moyens de commande peuvent de préférence être agencés pour arrêter le fonctionnement de la source lumineuse lorsque le signal de variation est sensiblement identique au signal de modulation.

De préférence, les moyens de modulation peuvent comprendre des moyens de régulation du courant électrique destiné à alimenter la source lumineuse.

De préférence, les moyens de régulation du courant électrique peuvent être aptes à fournir un courant électrique de valeurs moyennes différentes.

Les moyens de régulation du courant électrique peuvent de préférence comprendre un convertisseur de type Buck ou « step down ».

Le convertisseur de type Buck peut de manière préférentielle être apte à fournir un courant électrique de valeurs moyennes différentes selon la fréquence de découpage choisie et à tensions d'entrée et de sortie inchangées.

De préférence, les moyens de modulation peuvent être configurés pour moduler l'intensité lumineuse émise par la source lumineuse en alternant l'amplitude du courant ondulatoire du convertisseur selon un signal de modulation prédéterminé.

Les moyens de modulation peuvent préférentiellement être agencés pour moduler l'intensité lumineuse en alternant l'amplitude du courant de crête du convertisseur selon un signal de modulation prédéterminé

De préférence, les moyens de modulation peuvent comprendre un générateur apte à générer au moins un signal de modulation.

De préférence, les moyens de modulation peuvent comprendre un générateur de signaux de modulation.

Les moyens de conversion peuvent préférentiellement comprendre un matériau photo luminescent. Il peut par exemple s'agir d'un matériau phosphorescent.

De préférence, les moyens d'obtention du signal de variation peuvent comprendre un capteur optique sensible aux longueurs d'ondes de la lumière cohérente émise par la source lumineuse. Le capteur optique peut par exemple comprendre une photodiode.

Le capteur optique peut de préférence être sensible aux longueurs d'ondes de la lumière incohérente diffusée par les moyens de conversion.

De manière préférée, les moyens d'obtention du signal de variation peuvent comprendre un élément microcontrôleur relié de manière fonctionnelle au capteur optique.

Les moyens de commande peuvent de préférence comprendre un circuit électronique comparateur. De préférence, les moyens de commande peuvent comprendre un filtre de type passe-bande centré sur la fréquence de modulation du signal de modulation.

De préférence, les moyens de commande peuvent comprendre un élément microcontrôleur.

De préférence, les moyens de commande peuvent être configurés de manière à éteindre la source lumineuse lorsque la ou les caractéristiques comparées du signal de modulation et du signal de variation sont semblables. Les caractéristiques comparées peuvent de préférence comprendre la fréquence ou l'amplitude des signaux.

De préférence, les moyens de commande peuvent éteindre la source lumineuse lorsque les caractéristiques comparées diffèrent de moins de 20% l'une par rapport à l'autre.

La source lumineuse peut préférentiellement être de type semi-conducteur à rayonnement Laser.

Le module lumineux peut de préférence comprendre un élément optique positionné de façon à ce qu'au moins une partie de la lumière incohérente diffusée par les moyens de conversion est déviée selon au moins une direction prédéterminée.

L'élément optique peut comprendre un élément réflecteur.
De préférence, l'élément réflecteur peut comprendre une surface au moins partiellement réfléchissante apte à réfléchir la lumière incohérente diffusée par les moyens de conversion.

Alternativement, les moyens d'obtention peuvent être disposés sous l'élément réflecteur, de sorte à pouvoir recevoir des rayons réfléchis par ledit réflecteur

Un élément capteur optique des moyens d'obtention du signal de variation peut de préférence être logé au niveau d'une surface réfléchissante de l'élément réflecteur.

L'invention a également pour objectif un procédé de commande d'au moins une source lumineuse d'un module lumineux conforme à l'invention. La source lumineuse est apte à émettre de la lumière cohérente selon une direction d'émission. Le procédé est remarquable en ce qu'il comprend les étapes suivantes :
- modulation de l'intensité de la lumière émise par ladite source moyennant un signal de modulation ;
- obtention d'un signal de variation, indiquant la variation de l'intensité lumineuse de la lumière incidente sur les moyens d'obtention d'un signal de variation du module lumineux ;
- comparaison d'au moins une caractéristique du signal de variation et du signal de modulation, et
- éteignement de ladite source lumineuse lorsque la ou les caractéristiques comparées sont semblables.

Les caractéristiques comparées peuvent de préférence comprendre la fréquence ou l'amplitude des signaux.

De préférence, l'étape d'éteignement peut avoir lieu lorsque les caractéristiques comparées diffèrent de moins de 20% l'une par rapport à l'autre.

En utilisant les mesures de l'invention, il devient possible de proposer un module lumineux pour un véhicule automobile en utilisant une source à émission de lumière cohérente, tout en diminuant le risque d'échappement de lumière cohérente du dispositif, ce qui augmente la sécurité des usagers de la route. En effet, en utilisant le dispositif selon l'invention il devient moins probable qu'un oeil humain sur lequel la lumière issue du dispositif est incidente ne soit endommagé. En modulant la lumière cohérente émise, il devient possible de lui imputer des propriétés mesurables que ni lumière diffusée au sein du dispositif, ni la lumière ambiante externe ne possèdent. Selon un mode de réalisation préféré, la modulation de la lumière cohérente émise est générée par un convertisseur d'un circuit d'alimentation de la source lumineuse en question. En alternant au moins deux niveaux de courant moyens distincts, la fréquence de découpage du convertisseur est alternée de la même façon, ce qui résulte en une réduction d'ondes électromagnétiques issues du convertisseur. La réduction des émissions électromagnétiques au niveau du convertisseur permet à son tour l'utilisation de protections électromagnétiques moins performantes et moins onéreuses au sein du dispositif lumineux. En effet, les composants électroniques d'un tel dispositif sont sensibles aux émissions électromagnétiques.

D'autres caractéristiques et avantages de la présente invention seront mieux compris à l'aide de la description exemplaire et des dessins parmi lesquels :
- la figure 1 est une illustration schématique d'un module lumineux selon un mode de réalisation préféré de l'invention ;
- la figure 2 est un diagramme indiquant les étapes principales d'un procédé selon un mode de réalisation préféré de l'invention ;
- la figure 3 est une illustration schématique d'un module lumineux selon un mode de réalisation préféré de l'invention ;
- la figure 4 est une illustration d'un circuit électronique connue dans l'art pour la réalisation d'un convertisseur de type Buck ;
- la figure 5 montre l'évolution de l'intensité du courant électrique de sortie d'un convertisseur de type Buck selon l'axe temporel, en fonction de l'intensité moyenne du courant électrique émis.

Dans la description qui suit, des numéros de référence similaires seront utilisées pour décrire des concepts similaires à travers des modes de réalisation différents de l'invention. Ainsi, les numéros 100, 200 décrivent un module lumineux dans deux modes de réalisation différents conformes à l'invention.

Sauf indication spécifique du contraire, des caractéristiques techniques décrites en détail pour un mode de réalisation donné peuvent être combinés aux caractéristiques techniques décrites dans le contexte d'autres modes de réalisation décrits à titre exemplaire et non limitatif.

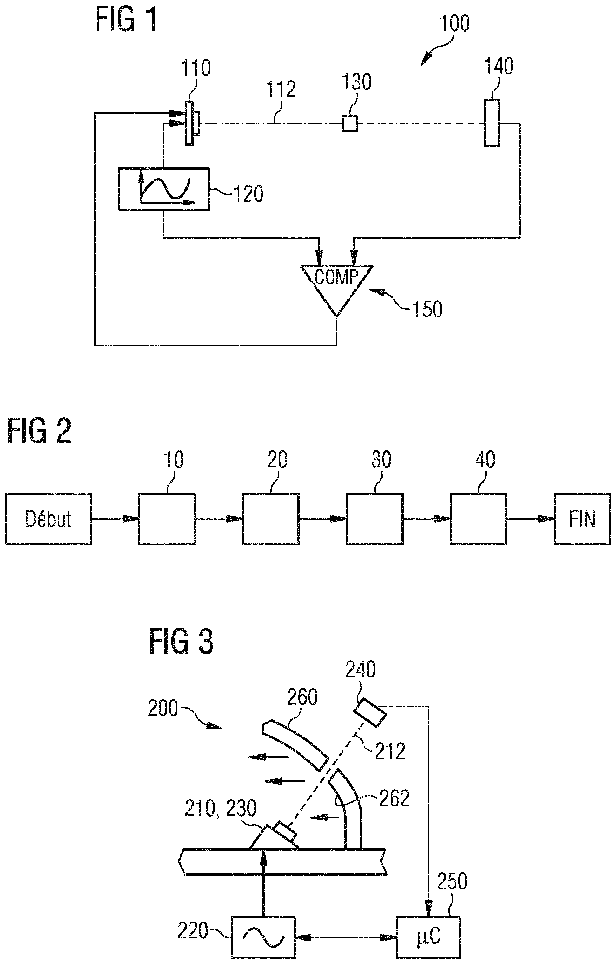

La figure 1 montre une représentation schématique d'un module lumineux 100 selon un mode de réalisation de l'invention. Une source lumineuse 110 est apte à émettre de la lumière cohérente selon une direction d'émission principale 112. Il s'agit à titre d'exemple d'une source à élément semi-conducteur, telle qu'une diode Laser. L'intensité de la lumière émise par la source est modulée à l'aide de moyens de modulation 120. Le signal de modulation peut présenter une allure sinusoïdale, ou présenter une alternance entre aux moins deux valeurs continues, par exemple. Des moyens de commande 150 sont reliés de manière fonctionnelle à la source lumineuse. Les moyens de commande peuvent par exemple comprendre un circuit de pilotage de l'alimentation électrique de la source lumineuse. Le module comprend des moyens de conversion 130, par exemple un matériau phosphorescent ou tout autre moyen de diffusion optique qui, suite à l'incidence de lumière cohérente, émet de la lumière incohérente et visible. Des moyens d'obtention d'un signal de variation 140 de l'intensité lumineuse reçue font également partie du module 100. Il s'agit par exemple d'un capteur optique sensible à l'intensité lumineuse dans une bande de fréquence correspondant à la longueur des ondes émises par la source lumineuse 110. L'arrangement est tel que la lumière cohérente modulée émise par la source 110 est incidente sur les moyens de conversion 130. Lorsque l'élément de conversion 130 est défectueux, les rayons de lumière cohérente continuent leur propagation en direction des moyens d'obtention d'un signal de variation 140. Donc, les moyens d'obtention d'un signal de variation 140 sont de préférence placés en alignement avec une direction d'émission 112, en aval de la source 110 et des moyens de conversion. Sur la figure 1, les moyens de conversion 130 et les moyens d'obtention d'un signal de variation 140 sont montrés sur des supports physiques qui les placent sur l'axe défini par la direction d'émission 112 respectivement. D'autres moyens de support seront à la portée de l'homme du métier sans pour autant sortir du cadre de la présente invention.

Le signal obtenu par les moyens d'obtention d'un signal de variation 140 est comparé au signal de modulation utilisée pour moduler l'intensité de la lumière émise par la source lumineuse 110. A cet effet, un circuit comparateur fait partie des moyens de commande 150. Lorsque le signal obtenu équivaut au signal de modulation, ceci indique que la lumière cohérente n'a pas été diffusée correctement par les moyens de conversion 130. Cette situation correspond à un défaut. Le comparateur permet de détecter ce défaut et de couper l'alimentation électrique de la source lumineuse 110 en conséquence. Lorsque le signal obtenu n'équivaut pas au signal de modulation, le fonctionnement du dispositif est jugé normal et l'alimentation électrique de la source lumineuse 110 est maintenue.

La figure 2 montre les étapes principales d'un procédé selon l'invention, selon lequel dans une première étape 10 l'intensité de la lumière émise par la source lumineuse est modulée à l'aide d'un signal de modulation. Lors d'une deuxième étape 20, le signal de variation qui vient d'être décrit est obtenu par les moyens d'obtention d'un signal de variation. Des caractéristiques du signal de modulation initial et du signal de variation ainsi obtenu sont comparées lors de l'étape 30 et finalement, lors de l'étape 40, la source lumineuse est éteinte par les moyens de commande en coupant l'alimentation électrique, lorsque les caractéristiques comparées sont semblables. Les caractéristiques comparées peuvent par exemple et à titre non-limitatif comprendre une fréquence des signaux, ou leur amplitude. L'étape d'éteignement a préférentiellement lieu lorsque les caractéristiques comparées diffèrent de moins de 20% l'une par rapport à l'autre.

La figure 3 montre un mode de réalisation préférentiel du module lumineux 200 selon l'invention. Le fonctionnement est analogue au fonctionnement décrit en rapport avec le mode de réalisation de la figure 1.

Une source lumineuse 210 est apte à émettre de la lumière cohérente selon une direction d'émission principale 212. L'intensité de la lumière émise par la source est modulée à l'aide de moyens de modulation 220. Des moyens de commande 250, comprenant par exemple un élément microcontrôleur programmable, sont reliés de manière fonctionnelle à la source lumineuse et aux moyens de modulation 220. Dans l'exemple montré, les moyens de conversion 230 sont intégrés à la source lumineuse 220. Il s'agit par exemple d'une couche fine de matériau phosphorescent qui vient revêtir la surface émettrice de puce laser semiconductrice 230. Des moyens d'obtention d'un signal de variation 240 sont arrangés sur l'axe défini par la direction d'émission. Le signal obtenu par les moyens d'obtention d'un signal de variation 240 est comparé au signal de modulation utilisée pour moduler l'intensité de la lumière émise par la source lumineuse 210. A cet effet, l'élément microcontrôleur 250 est adapté pour comparer des caractéristiques du signal de modulation d'une part, et du signal de variation obtenu d'autre part. Le module lumineux 200 comprend en outre un élément réflecteur 260 ayant une surface interne 262 au moins partiellement réfléchissante envers la lumière y incidente et diffusée par les moyens de conversion 230. La géométrie de la surface 262 est telle qu'au moins une partie de la lumière incohérente diffusée par les moyens de conversion est réfléchie selon au moins une direction prédéterminée. De préférence, il s'agit d'une direction unique, indiquée sur la figure 3 à titre exemplaire par des flèches. De préférence, les moyens d'obtention du signal de variation 240 sont logés généralement à ras de la surface réfléchissante 262 de l'élément réflecteur 260. Alternativement, comme indiqué sur la figure 3, la surface 262 comprend une ouverture placée telle que l'axe défini par la direction d'émission de la source lumineuse 210 la traverse. Les moyens d'obtention du signal de variation 240 sont alors placés derrière la surface réfléchissante 262 de l'élément réflecteur 260, dans la prolongation de cet axe.

Dans tous les modes de réalisation, les moyens de modulation peuvent de préférence être réalisés à l'aide d'un convertisseur de type abaisseur de tension, ou Buck (« step down »), faisant partie des moyens de pilotage de l'alimentation de la source lumineuse 110, 210. L'utilisation d'un convertisseur déjà présent dans une architecture connue permet de s'affranchir d'un circuit électronique dédié uniquement à la modulation de l'intensité lumineuse émise par la source en question, et résulte dans un gain d'espace et de coûts. De manière générale, l'intensité lumineuse émise par une source lumineuse à élément semi-conducteur dépend de l'intensité du courant électrique qui la traverse.

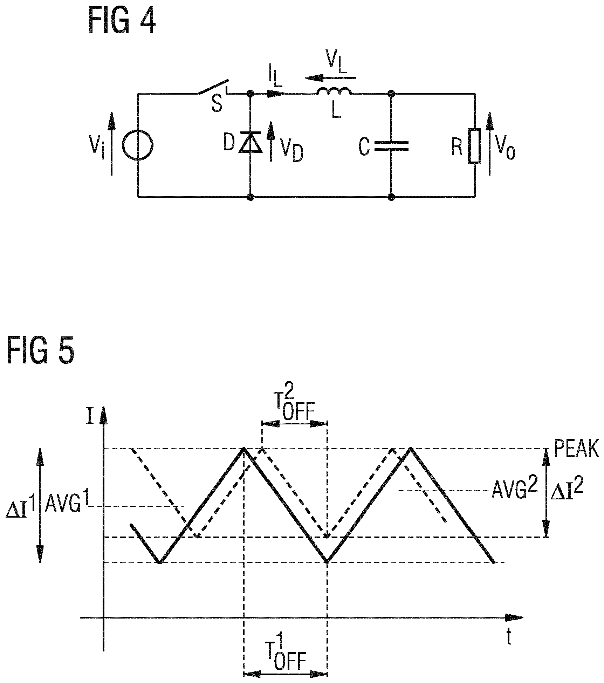

La figure 4 montre un circuit électronique qui sert à implémentée, de manière connue, un convertisseur de type Buck. Un tel convertisseur est un élément de régulation du courant électrique destiné à alimenter la source lumineuse. Le fonctionnement d'un convertisseur Buck peut être divisé en deux configurations suivant l'état de l'interrupteur S:
Dans l'état passant, l'interrupteur S est fermé, la tension aux bornes de l'inductance vaut V_{L}=Vᵢ-Vₒ. Le courant traversant l'inductance augmente linéairement. La tension aux bornes de la diode étant négative, aucun courant ne la traverse.
Dans l'état bloqué, l'interrupteur est ouvert. La diode devient passante afin d'assurer la continuité du courant dans l'inductance. La tension aux bornes de l'inductance vaut V_{L}= -Vₒ. Le courant traversant l'inductance décroît.

L'interrupteur du convertisseur est généralement réalisé par un transistor à effet de champ à grille isolée, MOSFET (« Metal Oxide Semiconductor Field Effect Transistor »). De tels transistors émettent un rayonnement électromagnétique dépendant de leur fréquence d'interruption ou fréquence de découpage.

Le convertisseur Buck est apte à fournir un courant électrique d'intensités moyennes différentes selon la fréquence de découpage choisie et à tensions d'entrée et de sortie inchangées. Il est notamment possible de programmer le courant ondulatoire (« ripple current ») et le courant de crête (« peak current ») d'un tel convertisseur à l'aide d'un microcontrôleur. En maintenant la tension d'entrée et la tension de sortie ainsi que l'intensité du courant de crête inchangées, mais on changeant l'amplitude du courant ondulatoire, il devient possible d'agir directement et rapidement sur la valeur moyenne de l'intensité de courant émis par le convertisseur. Comme l'intensité lumineuse de la source lumineuse à élément semi-conducteur alimentée dépend directement de l'intensité du courant émis, cette intensité lumineuse émise devient donc modulable en alternant l'amplitude du courant ondulatoire du convertisseur selon un signal de modulation prédéterminé.

La figure 5 illustre ce principe de fonctionnement. Dans une première phase, correspondant à un premier niveau de modulation, le courant ondulatoire a une amplitude indiquée par ΔI¹. La valeur moyenne de l'intensité de courant émise par le convertisseur est donnée par la valeur AVG¹, qui équivaut à l'intensité du courant de crête (valeur maximale atteinte) moins la moitié de la valeur AI¹. Dans cette phase, la période lors duquel l'interrupteur du Buck est ouvert, correspond à T¹_{OFF}.

Dans une deuxième phase, correspondant à un deuxième niveau de modulation, le courant ondulatoire a une amplitude indiquée par ΔI². A valeur de crête égale, la valeur moyenne de l'intensité de courant émise par le convertisseur est donnée par la valeur AVG². Dans cette phase, la période lors duquel l'interrupteur du Buck est ouvert, correspond à T²_{OFF}. Cette période a dans l'exemple montré une durée plus courte que la période T¹_{OFF}. La fréquence de découpage du convertisseur Buck est donc différente selon la valeur moyenne de l'intensité de courant émise par le convertisseur.

Il s'ensuit que, en modulant l'intensité lumineuse de la source lumineuse de la manière qui vient d'être décrite, le spectre d'émissions électromagnétiques issues du convertisseur Buck peut être étalé sur une gamme de fréquences qui correspond aux fréquences de découpage associées aux différents niveaux de modulation.

Lorsque le convertisseur fonctionne en utilisant une fréquence de découpage en continu, le spectre d'émissions électromagnétiques marque un pic autour de la fréquence de découpage. En alternant plusieurs fréquences de découpage dans le temps, ce qui est le cas lorsque l'intensité lumineuse de la source lumineuse est modulée, la position de ce pic d'émission dans le spectre suit la même alternance, de façon à ce que les émissions électromagnétiques peuvent être réduites en moyenne dans le temps.

A l'aide de la description qui vient d'être donné, l'homme du métier saura réaliser d'autres implémentations amenant l'effet qui vient d'être décrit, sans pour autant sortir du cadre de l'invention, qui est déterminé par l'étendue des revendications ci-jointes.

## Revendications

1. Module lumineux (100, 200) pour un véhicule automobile comprenant une source lumineuse (110, 210) adaptée pour émettre de la lumière cohérente, des moyens de modulation (120, 220) destinés à moduler l'intensité de la lumière émise par ladite source (110, 210) moyennant un signal de modulation,
des moyens de conversion (130, 230) agencés de sorte qu'au moins une partie de la lumière cohérente incidente en provenance de ladite source (110, 210) soit convertie en lumière incohérente,
**caractérisé en ce que** le module comprend en outre
des moyens d'obtention d'un signal de variation (140, 240), indiquant la variation de l'intensité lumineuse d'une lumière incidente, disposés en aval des moyens de conversion (130, 230), et
des moyens de commande (150, 250) de la source lumineuse (110, 210) qui sont configurés pour comparer le signal de variation au signal de modulation et pour commander le fonctionnement de ladite source lumineuse suite à la comparaison dudit signal de variation au signal de modulation.

2. Module lumineux selon la revendication 1, **caractérisé en ce que** les moyens de modulation (120, 220) comprennent des moyens de régulation du courant électrique destiné à alimenter la source lumineuse (110, 210).

3. Module lumineux selon la revendication 2, **caractérisé en ce que** les moyens de régulation du courant électrique comprennent un convertisseur de type Buck.

4. Module lumineux selon la revendication 3, **caractérisé en ce que** le convertisseur de type Buck est adapté pour fournir un courant électrique de valeurs moyennes différentes selon une fréquence de découpage choisie et à tensions d'entrée et de sortie inchangées.

5. Module lumineux selon une des revendications 1 à 4, **caractérisé en ce que** les moyens de modulation (120, 220) comprennent un générateur de signaux de modulation.

6. Module lumineux selon une des revendications 1 à 5, **caractérisé en ce que** les moyens de conversion (130, 230) comprennent un matériau photoluminescent.

7. Module lumineux selon une des revendications 1 à 6, **caractérisé en ce que** les moyens d'obtention du signal de variation (140, 240) comprennent un capteur optique sensible aux longueurs d'ondes de la lumière cohérente émise par la source lumineuse (110, 210).

8. Module lumineux selon la revendication 7, **caractérisé en ce que** le capteur optique est sensible aux longueurs d'ondes de la lumière incohérente diffusée par les moyens de conversion (130, 230).

9. Module lumineux selon une des revendications 7 ou 8, **caractérisé en ce que** les moyens d'obtention du signal de variation (140, 240) comprennent un élément microcontrôleur relié de manière fonctionnelle au capteur optique.

10. Module lumineux selon une des revendications 1 à 9, **caractérisé en ce que** la source lumineuse (110, 210) est de type semi-conducteur à rayonnement Laser.

11. Module lumineux (200) selon une des revendications 1 à 10, **caractérisé en ce que** le module comprend un élément optique (260) positionné de façon à ce qu'au moins une partie de la lumière incohérente diffusée par les moyens de conversion (230) est déviée selon au moins une direction prédéterminée.

12. Module lumineux selon la revendication 11, **caractérisé en ce que** l'élément optique comprend un élément réflecteur et **en ce qu'**un élément capteur optique des moyens d'obtention du signal de variation (240) est logé au niveau d'une surface réfléchissante (262) de l'élément réflecteur (260).

13. Procédé de commande d'au moins une source lumineuse d'un module lumineux selon une des revendications 1 à 12, la source lumineuse étant adaptée pour émettre de la lumière cohérente selon une direction d'émission, **caractérisé en ce que** le procédé comprend les étapes suivantes :
- modulation de l'intensité de la lumière émise par ladite source moyennant un signal de modulation (10);
- obtention d'un signal de variation, indiquant la variation de l'intensité lumineuse de la lumière incidente sur les moyens d'obtention d'un signal de variation du module lumineux (20);
- comparaison d'au moins une caractéristique du signal de variation et du signal de modulation (30), et
- éteignement de ladite source lumineuse lorsque la ou les caractéristiques comparées sont semblables (40).

14. Procédé selon la revendication 13, **caractérisé en ce que** les caractéristiques comparées comprennent la fréquence ou l'amplitude des signaux.

15. Procédé selon une des revendications 13 ou 14, **caractérisé en ce que** l'étape d'éteignement a lieu lorsque les caractéristiques comparées diffèrent de moins de 20% l'une par rapport à l'autre.

## Patentansprüche

1. Leuchtmodul (100, 200) für ein Kraftfahrzeug, umfassend
eine Lichtquelle (110, 210), die dazu angepasst ist, kohärentes Licht abzustrahlen,
Modulationsmittel (120, 220), die dazu bestimmt sind, die Intensität des von der Lichtquelle (110, 210) abgestrahlten Lichts mittels eines Modulationssignals zu modulieren,
Umwandlungsmittel (130, 230), die so gestaltet sind, dass mindestens ein Teil des von der Lichtquelle (110, 210) kommenden einfallenden kohärenten Lichts in inkohärentes Licht umgewandelt wird,
**dadurch gekennzeichnet, dass** das Modul darüber hinaus umfasst
Mittel zum Erhalten eines Änderungssignals (140, 240), das die Änderung der Lichtintensität eines einfallenden Lichts angibt, die den Umwandlungsmitteln (130, 230) nachgelagert angeordnet sind, und
Steuermittel (150, 250) zum Steuern der Lichtquelle (110, 210), die dazu ausgestaltet sind, das Änderungssignal mit dem Modulationssignal zu vergleichen und den Betrieb der Lichtquelle nach dem Vergleichen des Änderungssignals mit dem Modulationssignal zu steuern.

2. Leuchtmodul nach Anspruch 1, **dadurch gekennzeichnet, dass** die Modulationsmittel (120, 220) Mittel zur Regelung des elektrischen Stroms umfassen, der dazu bestimmt ist, die Lichtquelle (110, 210) zu versorgen.

3. Leuchtmodul nach Anspruch 2, **dadurch gekennzeichnet, dass** die Mittel zur Regelung des elektrischen Stroms einen Abwärtswandler umfassen.

4. Leuchtmodul nach Anspruch 3, **dadurch gekennzeichnet, dass** der Abwärtswandler dazu angepasst ist, einen elektronischen Strom mit unterschiedlichen Mittelwerten je nach einer gewählten Schaltfrequenz und bei unveränderten Eingangs- und Ausgangsspannungen abzugeben.

5. Leuchtmodul nach einem der Ansprüche 1 bis 4, **dadurch gekennzeichnet, dass** die Modulationsmittel (120, 220) einen Modulationssignalgenerator umfassen.

6. Leuchtmodul nach einem der Ansprüche 1 bis 5, **dadurch gekennzeichnet, dass** die Umwandlungsmittel (130, 230) ein fotolumineszentes Material umfassen.

7. Leuchtmodul nach einem der Ansprüche 1 bis 6, **dadurch gekennzeichnet, dass** die Mittel zum Erhalten des Änderungssignals (140, 240) einen optischen Sensor umfassen, der empfindlich gegenüber den Wellenlängen des von der Lichtquelle (110, 210) abgestrahlten kohärenten Lichts ist.

8. Leuchtmodul nach Anspruch 7, **dadurch gekennzeichnet, dass** der optische Sensor empfindlich gegenüber den Wellenlängen des von den Umwandlungsmitteln (130, 230) gestreuten inkohärenten Lichts ist.

9. Leuchtmodul nach einem der Ansprüche 7 oder 8, **dadurch gekennzeichnet, dass** die Mittel zum Erhalten des Änderungssignals (140, 240) ein Mikrocontrollerelement umfassen, das in Wirkverbindung mit dem optischen Sensor steht.

10. Leuchtmodul nach einem der Ansprüche 1 bis 9, **dadurch gekennzeichnet, dass** die Lichtquelle (110, 210) vom Typ Halbleiter mit Laserstrahlung ist.

11. Leuchtmodul (200) nach einem der Ansprüche 1 bis 10, **dadurch gekennzeichnet, dass** das Modul ein optisches Element (260) umfasst, das so positioniert ist, dass mindestens ein Teil des von den Umwandlungsmitteln (230) gestreuten inkohärenten Lichts entlang mindestens einer vorgegebenen Richtung umgelenkt wird.

12. Leuchtmodul nach Anspruch 11, **dadurch gekennzeichnet, dass** das optische Element ein Reflektorelement umfasst und dass ein optisches Sensorelement der Mittel zum Erhalten des Änderungssignals (240) auf Ebene einer reflektierenden Oberfläche (262) des Reflektorelements (260) untergebracht ist.

13. Verfahren zur Steuerung mindestens einer Lichtquelle eines Leuchtmoduls nach einem der Ansprüche 1 bis 12, wobei die Lichtquelle dazu angepasst ist, kohärentes Licht entlang einer Abstrahlungsrichtung abzustrahlen, **dadurch gekennzeichnet, dass** das Verfahren die folgenden Schritte umfasst:
- Modulation der Intensität des von der Quelle abgestrahlten Lichts mittels eines Modulationssignals (10) ;
- Erhalten eines Änderungssignals, das die Änderung der Lichtintensität des auf die Mittel zum Erhalten eines Änderungssignals des Leuchtmoduls einfallenden Lichts angibt (20);
- Vergleichen mindestens eines Merkmals des Änderungssignals und des Modulationssignals (30) und
- Ausschalten der Lichtquelle, wenn das oder die verglichenen Merkmale ähnlich sind (40).

14. Verfahren nach Anspruch 13, **dadurch gekennzeichnet, dass** die verglichenen Merkmale die Frequenz oder die Amplitude der Signale umfassen.

15. Verfahren nach einem der Ansprüche 13 oder 14, **dadurch gekennzeichnet, dass** der Schritt des Ausschaltens stattfindet, wenn die verglichenen Merkmale um weniger als 20 % voneinander abweichen.

## Claims

1. Lighting module (100, 200) for a motor vehicle, including
a light source (110, 210) adapted to emit coherent light,
modulation means (120, 220) for modulating the intensity of the light emitted by said source (110, 210) in accordance with a modulation signal, conversion means (130, 230) such that at least a portion of the incident coherent light coming from said source (110, 210) is converted into incoherent light,
**characterized in that** the module further includes means (140, 240) for producing a variation signal indicating the variation of the luminous intensity of incident light disposed downstream of the conversion means (130, 230), and
means (150, 250) for controlling the light source (110, 210) configured to compare the variation signal to the modulation signal and to control the operation of said light source following the comparison of said variation signal to said modulation signal.

2. Lighting module according to Claim 1, **characterized in that** the modulation means (120, 220) include means for regulating the electrical current supplying power to the light source (110, 210).

3. Lighting module according to Claim 2, **characterized in that** the means for regulating the electrical current include a Buck converter.

4. Lighting module according to Claim 3, **characterized in that** the Buck converter is adapted to supply an electrical current with different average values according to a chosen chopping frequency and with unchanged input and output voltages.

5. Lighting module according to any one of Claims 1 to 4, **characterized in that** the modulation means (120, 220) include a modulation signal generator.

6. Lighting module according to any one of Claims 1 to 5, **characterized in that** the conversion means (130, 230) include a photoluminescent material.

7. Lighting module according to any one of Claims 1 to 6, **characterized in that** the means (140, 240) for producing the variation signal include an optical sensor sensitive to the wavelength of coherent light emitted by the light source (110, 210).

8. Lighting module according to Claim 7, **characterized in that** the optical sensor is sensitive to the wavelength of incoherent light diffused by the conversion means (130, 230).

9. Lighting module according to either one of Claims 7 and 8, **characterized in that** the means for producing the variation signal (140, 240) include a microcontroller functionally connected to the optical sensor.

10. Lighting module according to any one of Claims 1 to 9, **characterized in that** the light source (110, 210) is of the semiconductor laser type.

11. Lighting module (200) according to any one of Claims 1 to 10, **characterized in that** the module includes an optical element (260) positioned so that at least a portion of the incoherent light diffused by the conversion means (230) is deflected in at least one predetermined direction.

12. Lighting module according to Claim 11, **characterized in that** the optical element includes a reflector element and **in that** an optical sensor of the means (240) for producing the variation signal is accommodated in a reflective surface (262) of the reflector element (260).

13. Method of controlling at least one light source of a lighting module according to any one of Claims 1 to 12, the light source being adapted to emit coherent light in an emission direction, **characterized in that** the method includes the following steps:
- modulating (10) the intensity of the light emitted by said source using a modulation signal,
- producing (20) a variation signal indicating the variation of the luminous intensity of the light incident on the means of the lighting module for producing a variation signal,
- comparing (30) at least one characteristic of the variation signal and the modulation signal, and
- extinguishing (40) said light source if the compared characteristic or characteristics are similar.

14. Method according to Claim 13, **characterized in that** the compared characteristics include the frequency or the amplitude of the signals.

15. Method according to either one of Claims 13 and 14, **characterized in that** the extinguishing step takes place if the compared characteristics differ from one another by less than 20%.
